# EUROPEAN PATENT SPECIFICATION

(11) **EP 4 066 060 B1**
(45) Date of publication and mention of the grant of the patent: **13.08.2025**
(21) Application number: 20714667.1
(22) Date of filing: 03.04.2020
(51) Int. Cl.: G03F 7/20, H01L 21/673, G03F 1/66, B65G 1/04, B65G 1/16, G03F 1/24

(54) **EUV RETICLE STOCKER AND METHOD OF OPERATING THE SAME**
EUV-RETIKEL-SPEICHER UND VERFAHREN ZUM BETREIBEN DESSELBEN
DISPOSITIF DE STOCKAGE DE RÉTICULES EUV ET SON PROCÉDÉ DE FONCTIONNEMENT

(30) Priority: 25.11.2019 EP 19211321
(43) Date of publication of application: 05.10.2022
(73) Proprietor: Brooks Automation (Germany) GmbH, 78256 Steißlingen (DE)
(72) Inventor: REBSTOCK, Lutz, 78343 Gaienhofen (DE); FENNER, Yves, 8572 Berg (CH); RAHRBACH, Bernd, 78467 Konstanz (DE); MEIER, Karl, 8240 Thayngen (CH)
(74) Representative: Dehns Germany Partnerschaft mbB
(86) International application number: PCT/EP2020/059648
(87) International publication number: WO 2021/104681

(56) References cited:
- JP-A- 2006 184 442
- US-A1- 2011 001 955
- US-A1- 2012 200 835
- US-A1- 2013 126 378
- US-A1- 2015 131 069

## Description

The present invention relates to a clamping device and a stocker for EUV reticles and a method of operating said reticle stocker.

### Background

Photolithography processes are widely used as one of the key steps in the manufacture of integrated circuits (ICs) and other semiconductor-related devices and/or structures. However, as the dimensions of features produced by such processes decrease, the importance of photolithography for the production of miniature ICs or other devices and/or structures rises.

In photolithography, a geometric pattern is transferred from a photomask (typically referred to as reticle) onto a substrate, for example a semiconductor wafer, by the use of light, a photosensitive layer and a subsequent etching step. Depending on the desired feature size on the substrate, the feature size of the reticle needs to be adapted as well as the wavelength of the light used for pattern transfer, with consideration of the Raleigh criterion.

In order to reduce the smallest achievable feature size, it has been proposed to use extreme ultraviolet (EUV) radiation. EUV radiation is electromagnetic radiation having a wavelength within the range of 5-20 nm, for example within the range of 5-10 nm.

Any contamination of the reticle may reduce the imaging performance of the photolithographic process and may in more serious cases require the reticle to be replaced. The reticle is typically expensive and therefore any reduction in the frequency with which it must be replaced is advantageous. Furthermore, replacement of the reticle is a time consuming process, during which the photolithographic process may have to be supported, thereby reducing its efficiency, which is undesirable.

For EUV applications, particle contamination with particle sizes of less than 10 nm as well as chemical contamination, for example by adsorption of volatile organic compounds, can be relevant.

The reticles used for such EUV applications are therefore typically stored in a storage stocker, and retrieved when needed in connection with the lithography exposure equipment. Usually, the reticles are contained in a double shell container (double pod) comprising a socalled EUV outer pod (EOP) and an EUV inner pod (EIP).

Such a double pod is described in further detail in US 2019/0214287 A1, for example.

Since the acceptable level of particle contamination is extremely small, friction (which leads to abrasion and thus particle generation) of the reticle against the container as well as friction of container components relative to one another needs to be avoided. Therefore, typical EIPs are designed so as to accommodate one reticle in such a way that it has only very limited possibilities to move therein. They are also equipped with additional reticle immobilization means to immobilize the reticle inside the EIP. In order to prevent contamination, the EIP is designed to enable a protective gas or vacuum to be applied to the reticle. To that end, typically orifices equipped with filter material are provided for the protective gas to enter from the EOP into the surroundings of the reticle contained in the respective EIP.

The EOP is equipped with actuation means adapted to bias the reticle immobilization means of the EIP into a retaining position, thereby immobilizing the reticle inside the EIP when the EOP is attached to the EIP. The EOP also functions to immobilize the typically two pieces of the EIP against one another to prevent friction induced abrasion.

A clamping device for immobilizing the EIP during times of storage, for example, are disclosed in US 2011/0001955 A1, in which systems and methods to protect a reticle from being contaminated by airborne particles are described. Those systems and methods include providing a reticle secured in a two-part cover. The two part cover includes a removable protection device used to protect the reticle from contaminants. The cover can be held inside a pod or box that can be used to transport the cover through a lithography system from an atmospheric section to a vacuum section. While in the vacuum section, the removable cover can be moved during an exposure process during which a pattern on the reticle can be formed on a wafer.

According to US 2015/0131069 A1, a reticle protection device capable of keeping a reticle therein is provided with an inner pod capable of keeping the reticle therein; an outer pod capable of keeping the inner pod therein; an electroconductive movable contact portion provided on at least one of the inner pod and the outer pod and being capable of coming into contact with an electroconductive film of the reticle; and a leaf spring for achieving electric conduction of the contact portion to at least one of the inner pod and the outer pod. The reticle is kept in the inner pod and the inner pod is kept in the outer pod, thereby enabling stable grounding of the reticle.

### Summary

It is to be understood that the EIP components are moveable against one another as long as they are not immobilized from outside. In order to avoid friction induced abrasion caused by such movement, the EOP conventionally provides such immobilization functionality for the EIP while also providing protection against the surrounding atmosphere, which is necessary e.g. during transport between a storing position and process tools requiring reticles for operation.

EOPs are rather bulky, leading to high space requirements or "footprint" for stockers storing EUV reticles. Furthermore, they are made of polymeric material, which is also prone to abrasion and outgassing of volatile organic compounds.

The present invention attempts to solve these problems by providing methods, devices and systems with features according to the independent claims. Advantageous embodiments and additional features are provided in the dependent claims and discussed in the following description.

The present invention enables reducing the required space for storing reticles while ensuring at least the same level of contamination and damage protection provided by conventional systems. Chemical contamination during storage from outgassing EOPs is prevented and mechanical damage protection improved over storing reticles in double pods. For example, EOPs can easily be damaged during an earthquake, while devices according to the present invention are less fragile, even under such challenging conditions, as will be understood from the following description.

Aspects which need to be taken into account when developing such an improved storage concept include that it is highly undesirable to change the way the reticles are provided to the photolithographic process equipment, this typically being the most complicated and costly part of a semiconductor production facility.

Therefore, since the photolithographic process equipment is typically adapted to receive double pods, means for providing a conventional double pod to the photolithographic process equipment are advantageously provided with the improved reticle stocker.

In one aspect of the invention, a clamping device for an EUV inner pod (EIP) is provided, the EIP comprising two or more components and containing or adapted and configured to contain an EUV reticle, wherein the clamping device is configured to immobilize the two or more components of the EIP and the reticle relative to one another, and to only partially cover the EIP. For example, only a fraction amounting to less than 90%, 80%, 75%, 50%, 25%, 20% or 10% of an outer surface of the EIP is covered by the clamping device according to the invention. The clamping device, therefore, allows e.g. the atmosphere surrounding the clamping device to come into contact with the EIP, thus e.g. obviating the need for sophisticated supply means for protective gasses.

Be it noted that the clamping device can also be used for clamping the components of the EIP together, even if this does not hold a reticle. In this case, only the components of the EIP are immobilized relative to one another.

Advantageously, the clamping device is further configured to act upon a retention means of the EIP, the retention means being configured to immobilize the reticle therein, when acted upon from outside the EIP, to immobilize the reticle within the EIP. Therefore, the immobilization of the reticle within the EIP is effected through the clamping device acting upon the retention means provided with the EIP. This provides the advantage, that existing systems can continue to be used without the need for retrofitting, thus avoiding costly investments.

Advantageously, the clamping element is mainly made of metallic materials, the metallic materials comprising preferably at least 75 %, 80 %, 90 %, 95 % or 99 %, with respect to total device volume and/or mass. This mitigates the above mentioned problem of chemical contamination through outgassing of polymeric materials. Thereby the required amount of purging gases and the frequency of necessary reticle replacement can be reduced. Other possible materials with similar advantages are, for example, polycarbonates (PC), poly ethyl ether ketones (PEEK) or cyclo olefin (co)polymers (COC / COP). The uniting feature of these materials is a particularly low outgassing characteristic.

In a first alternative according to this invention, the clamping device is provided with two clamping elements comprising an upper clamping element and a lower clamping element which are configured to be attachable to one another while accommodating the EIP between them. Particularly, the movement required for assembling such a clamping device around an EIP is substantially normal towards a main surface of the EIP and lateral movements with respect to the EIP are substantially not required. This facilitates the assembly process and reduces the risk of friction induced particle generation (abrasion).

Advantageously, the upper clamping element is configured to act upon the retention means of the EIP to immobilize the reticle therein. It can thus replace or emulate the immobilization function that the EOP traditionally fulfils without the drawbacks in terms of chemical contamination and spatial footprint.

In a second alternative according to this invention, the clamping device comprises one clamping element and one, two or more fixation means, wherein the fixation means are biased towards a closed position and are configured to be moved into an open position; wherein the clamping device is configured to be attachable to an EIP, when the fixation means are in the open position and to immobilize the EIP components and the reticle relative to one another, when the fixation means are in and/or brought into the closed position In other words, the clamping device is provided as a single or one-piece clamping element comprising fixation means. The fixation means act upon an underside of an EIP, when the clamping device is attached to the EIP, and on a top side of the clamping element. Otherwise this single clamping element provides the same functionality as the upper clamping element described above. This one-piece-embodiment is favourable in terms of handling, since only one piece is required to provide the same functionality. This one piece is attached to the EIP from the top side of the EIP. Therefore, fewer handling steps are required for attaching the clamping device to an EIP, as compared to the two-piece embodiment described above.

Advantageously, the clamping device comprises actuators configured to act upon the retention means, when the clamping device is attached to the EIP.

Advantageously, the clamping device has an envelope volume of less than 130 %, 120 %, 110 %, 105 % or even less than 100 % of an envelope volume of an EIP to which the clamping device is attachable.

Particularly the clamping device has an envelope volume which is less than 130 %, 120 %, 110 % or 105 % of the envelope volume of the EIP, thus substantially reducing the spatial footprint of storing a reticle compared to storage within a double pod comprising an EIP and an EOP. This may also reduce the required amount of purging gases, as mentioned above. An envelope volume, for example, can be understood as describing the volume of the smallest possible cuboid completely containing a respective object.

The clamping device according to some embodiments may be equipped with an information carrying element, such as an RFID device or a visually detectable code such as a bar code, a QR code or other forms of 1D or 2D codes. This provides the advantage that information about the reticle can be associated with the corresponding clamping device. Therefore, it may be possible, for example, to identify a stored reticle solely by identifying the clamping device associated with it.

Furthermore, such information can be used for tracking purposes, for example to count the number of storage operations performed with a given clamping device. This is useful in order to determine the appropriate time for cleaning or replacement procedures or functionality tests.

In some embodiments, a sensor for monitoring certain conditions during storage and handling, such as humidity, temperature, pressure, acceleration or the concentration of certain chemical species in the storage atmosphere and the like is included in the clamping device. This provides the advantage of knowledge of influencing factors experienced by reticles throughout their storage history and can therefore improve the overall productivity of a production facility in which the present invention is used.

Such information can be stored and processed in a memory and/or processor provided with the clamping device or in a component of a machine or tool handling a storage system according to the invention.

In another aspect, the present invention provides a storage system comprising a clamping device as described above and an EIP. The EIP comprises two or more components, is configured to accommodate an EUV reticle and comprises a retention means configured to immobilize a reticle contained within the EIP when the retention means is acted upon from outside the EIP. The clamping device is attached to the EIP to immobilize the two or more components of the EIP relative to one another and acts upon the retention means, thus immobilizing the reticle within the EIP. Therefore, abrasion can be substantially avoided and contamination of the reticle by particles in a relevant size range minimized.

Typically, the retention means is provided in the form of one or more pistons penetrating one of the EIP components. Each of the pistons is elastically biased into a retracted position and is adapted to apply a normal force onto the reticle when acted upon from outside the EIP. At the same time, the retention means is in sealing engagement with the EIP component it penetrates in order to protect the reticle stored within the EIP from contamination with contaminants from outside the EIP.

In a preferred embodiment, the storage system has an envelope volume of less than 130 %, 120 %, 110 % or 105 %, compared to the envelope volume of the EIP. As such, the space required for storing a reticle is significantly reduced in relation to conventional storage systems in the form of a double pod comprising an EIP and an EOP.

Another aspect of the invention provides a method of operating an EUV reticle stocker, comprising storing reticles in the reticle stocker and retrieving reticles from the reticle stocker, wherein the storing comprises moving a storage system according to the invention containing a reticle to a storage position within the EUV reticle stocker; and the retrieving comprises removing a storage system according to the invention containing a reticle from its storage position. This reduces the required space for storing reticles in comparison to conventional storage methods.

The storing, before the step of moving to a storage position, according to the invention further comprises the steps of: receiving, from outside the stocker, a double pod comprising an EUV outer pod (EOP) and an EIP containing an EUV reticle, wherein the EIP is entirely contained within the EOP; opening the EOP; and attaching a clamping device to the EIP to immobilize EIP components relative to one another and to act upon the retention means provided in the EIP to immobilize the reticle relative to the EIP to provide the storage system.

Therefore, the storage system is provided by the improved stocker itself, making it possible to directly utilise the stocker in conjunction with an existing manufacturing process without substantially altering any process steps carried out outside the stocker.

In a preferred embodiment, receiving a double pod comprises accepting the double pod at an outwardly facing side of an entrance terminal comprising an airlock, opening a first shutter of the airlock, moving the double pod into the airlock, closing the first shutter, decontaminating an inner volume of the airlock, opening a second shutter of the airlock, moving the double pod through the second shutter to an inwardly facing side of the entrance terminal, and closing the second shutter. In other words, the double pod it is passed through the airlock from an outwardly facing side to an inwardly facing side of the entrance terminal, including a decontamination of the inner volume of the airlock, while the double pod is inside the airlock. This provides the advantage of avoiding contamination of the stocker.

Opening of an EOP may include unlocking the EOP, removing it from around the EIP and storing it in an EOP buffer stock. The EOP buffer stock is preferably separated from the storage positions for the storage system described above, in order to prevent cross contamination from the outer side of the EOP to the EIP. Thus, strict cleanliness requirements can be met while reducing the space needed for storing reticles.

The retrieving of reticles after the step of removing the storage system from its storage position preferably further comprises detaching the clamping device from the EIP, assembling an EOP around the EIP to immobilize the EIP components and the reticle contained within the EIP relative to each other, forming a double pod, and delivering the double pod to outside the stocker, preferably by passing it through an airlock in order to prevent contamination of the stocker atmosphere. This provides the advantage that standard double pods can be used with the production process in the facility, thereby enabling conventional process equipment to profit from the improved storage conditions provided in connection with this invention.

The EOP used for this assembling can preferably be retrieved from the above mentioned EOP buffer stock. This provides the advantage that an EOP is not required for every reticle to be stored, while ensuring timely supply of any reticles required for the manufacturing process. In other words, the number of reticles stored can significantly exceed the number of EOPs provided. In other words, only those reticles required outside the stocker at any given time require an EOP during that time.

Preferably, it is ensured, during any step performed at a time when the reticle is not immobilized relative to the EIP, that the reticle and/or EIP components are not moved relative to one another, in order to prevent abrasion and corresponding particle generation.

In cases in which the clamping device is provided with an information carrying element, as described above, the method can advantageously comprise one or more steps in which information carried by the clamping device is read, written, deleted or altered. In such steps information about the identity of a reticle associated with a handled clamping device, the storage conditions a reticle experienced or other pieces of information can be used for controlling the reticle stocker or other tools, machines or devices in order to provide improved overall performance of the production facility.

The method may further comprise reading, receiving or otherwise collecting information provided by the one or more sensors optionally provided with the clamping device in order to monitor a history of storage conditions, the reticle has experienced. This provides the advantage that those reticles which are more likely to have deficiencies regarding quality can, for example, be inspected prior to use in the manufacturing of semiconductor products to ensure their integrity. Thereby, the output of faulty products is minimized.

In a further aspect of the invention, a stocker for storing at least one EUV reticle is provided, wherein each of the at least one reticle is stored or adapted and configured to be stored in one respective EUV inner pod (EIP), wherein the EIP comprises two or more EIP components which are immobilized relative to one another by a clamping device, wherein the EIP comprises retention means configured to immobilize the reticle stored inside the EIP relative to the EIP, when acted upon from outside the EIP, wherein the clamping device acts upon the retention means to immobilize the reticle stored within the EIP, the stocker comprising: a loading port (also referred to as entrance terminal in the language of this disclosure) comprising an airlock and an assembler; a storage unit configured to store EIPs each immobilized by one clamping device and each containing one reticle; and a handler configured to move the clamped EIP containing the reticle to and from a storage position within the stocker; wherein the airlock is configured to receive a double pod comprising an EUV outer pod (EOP) and an EIP containing a reticle from outside the stocker, wherein the EOP acts upon the retention means; and the assembler is configured to open the EOP without causing movement of EIP components and the reticle relative to one another; to attach said clamping device to and remove the clamping device from said EIP without causing movement of the EIP components and the reticle relative to one another; and to assemble an EOP around the unclamped EIP.

Advantageously, the stocker further comprises an EOP buffer stock, configured to store a number of EOPs in a controlled atmosphere with handling means configured to place an EOP into and retrieve an EOP from the EOP buffer stock.

In other words, the stocker is adapted to implement the above described method(s) and therefore profits from the same advantages as the method described above.

### Brief description of the drawings

Advantages and further aspects of the invention will now be discussed in further detail with reference to the accompanying drawings, wherein
Figure 1 shows two different embodiments of an EIP, in connection with which the present invention can be implemented;
Figure 2 schematically shows a perspective view of an advantageous embodiment of a clamping device according to the invention;
Figure 2A shows a top view of an upper clamping element for two advantageous embodiments of a two-piece clamping device according to the invention;
Figure 3 schematically shows a perspective view of a preferred embodiment of a storage system according to the invention;
Figures 4A and 4B show flow charts representing preferred embodiments of an operating method for an EUV reticle stocker according to the invention;
Figures 5A and 5B schematically show another advantageous embodiment of a clamping device according to the invention;
Figure 6 shows a schematic representation of preferred embodiments of a storage system comprising a one-piece clamping device according to the invention in perspective and plan views; and
Figure 7 schematically shows an advantageous embodiment of a reticle stocker according to the invention.

### Detailed description

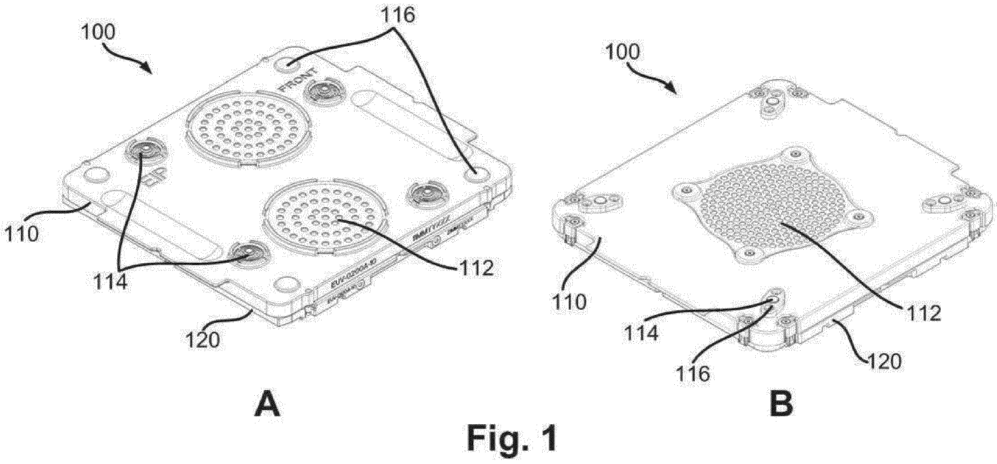

Two embodiments A, B of a conventional EIP generally designated 100 are shown in Fig. 1. Each EIP 100 comprises an upper component 110 and a lower component 120. The upper component 110 comprises one or more orifices 112, retention means 114 and pressure points 116.

The retention means 114 are provided in the form of four pistons, biased into a retracted position by elastic elements and connected to the upper component 110 in a sealing manner by elastic sealing means to prevent particulate contaminants from entering the inside of the EIP.

The orifices 112 are equipped with filter material also preventing particulate contaminants from entering the inside of the EIP while providing access for purging and/or protective gas(es) such as nitrogen.

The pressure points 116 are provided for immobilizing the two components 110, 120 relative to one another and the retention means are provided for immobilizing a reticle inside the EIP when acted upon from outside the EIP.

Pressure points similar to the pressure points 116 of the upper component 110 may also be provided with the lower component 120.

In embodiment A of EIP 100, the pressure points 116 are spatially separated from the retention means 114, while in embodiment B, the retention means 114 are provided within the same area as the pressure points 116 and extend through the pressure points 116.

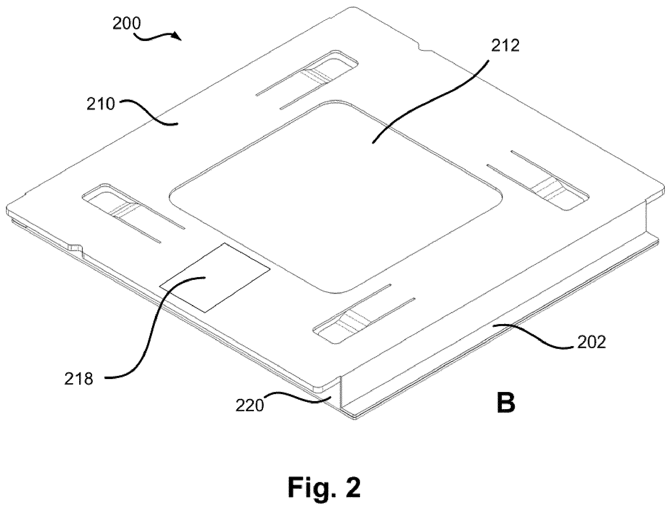

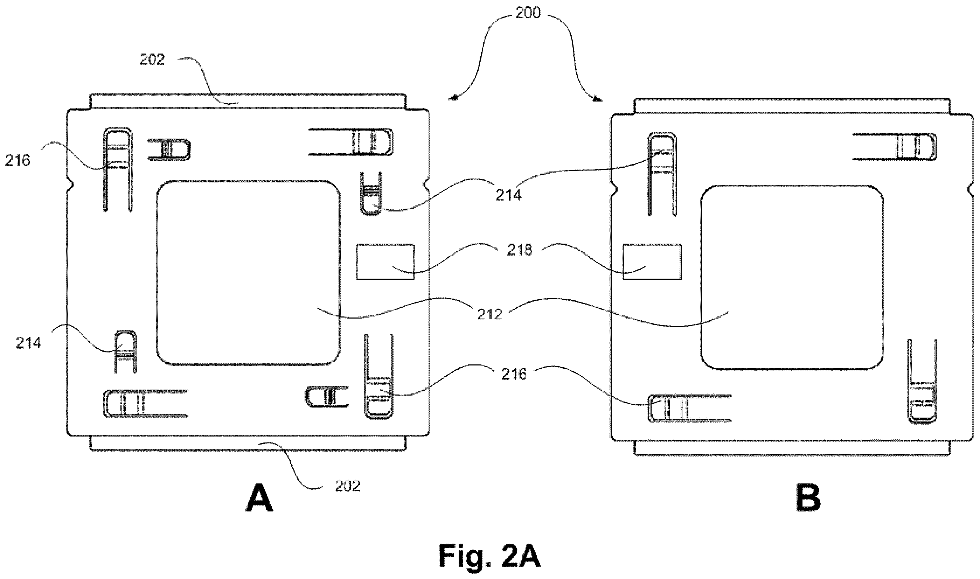

In Fig. 2 and 2A clamping devices 200 usable in connection with embodiments A, B of EIP 100 are schematically depicted.

The clamping device 200 comprises two elements 210, 220 made of sheet metal, one of which is an upper clamping element 210 featuring an orifice 212 substantially corresponding to the one or more orifices 112 of the EIP in terms of location and is formed to fit onto EIP 100. The part of the surface of EIP 100, which corresponds to the orifice 212 in terms of location, is referred to as "not covered" in the language of this disclosure, while particularly portions of the surface of EIP 100, which are in contact with or located directly opposite or under a material surface of the clamping device, are considered to be "covered". Therefore, according to the invention, clamping device 200 is configured to only partially cover EIP 100. The orifice 212 can especially take up more than 10%, 20%, 25%, 50%, 75%, 80% or 90% of the surface area of the upper clamping element 210. Furthermore, a similar orifice may also be provided in the lower clamping element 220 (not shown in the figures). Additionally, a sideways facing surface of EIP 100, which is in correspondence with neither of the upper 210 or lower 220 clamping elements is also considered "not covered".

Second element 220 forming a lower clamping element is essentially flat and corresponds to the upper clamping element 210 in size and shape and contour.

The upper 210 and lower 220 clamping elements are attachable to one another and are configured to accommodate and immobilize the EIP 100 between them when attached to one another. To that end, the upper and lower clamping elements are both equipped with pressing means 216, which are configured to press against the respective pressure points 116 of the upper and lower components 110, 120 of the EIP 100 to immobilize the EIP components 110, 120 relative to one another.

Further, actuators 214 are provided with the upper clamping element 210 for embodiment A of EIP 100 which are configured to act upon the retention means 114 of the upper component 110 of embodiment A of EIP 100, when the clamping device 200 is attached to EIP 100.

In the clamping device 200 adapted for use with embodiment B of EIP 100, pressing means 216 simultaneously fulfil the function of actuators 214. Thus, each pressing means 216 also constitutes an actuator 214.

For both embodiments shown, by acting upon the retention means 114 of EIP 100, the clamping device 200 immobilizes the reticle contained within EIP 100 relative to the EIP 100.

The pressing means 216 and the actuators 214 are provided in the form of tongue shaped cut-outs and can be configured to apply predetermined forces to the pressure points 116 and the retention means 114, respectively. Advantageously the pressing means 216 are configured to apply a predetermined force to each of the pressure points 116. In the clamping device for use with embodiment A of EIP 100, this force applied to the pressure points may be different from the predetermined force the actuators 214 apply to the retention means 114. As such, the forces applied to the retention means 114 and the pressure points 116 can be adapted to the required forces needed for immobilizing the respective parts relative to one another. Typically, the forces required for immobilizing the reticle within the EIP are smaller than the forces required for immobilizing the upper component 110 relative to the lower component 120. Therefore, a tongue shaped cut-out forming an actuator 214 may be longer and/or narrower than a cut-out forming a pressing means 216.

In the clamping device adapted to be usable with embodiment B of EIP 100, it is also possible to apply different forces to the pressure points 116 and the retention means 114, respectively, for example by providing an additional tongue shaped cut-out (not shown in the figures) within the pressing means 216, so that a smaller force may be applied to the retention means 114 as compared to the force applied to the pressure points 116. In other words, even though the pressure points 116 and retention means 114 in the embodiment B of EIP 100 are in close proximity, it is still possible to provide pressing means 216 and actuators 214 separately from one another.

The upper clamping element 210 is provided with fixation means 202 which are configured to fixedly attach the upper clamping element 210 to the lower clamping element 220 so as to provide the clamping device 200. In the example shown in Fig. 2 and 2A, the fixation means 202 are provided in the form of a latch, but other forms of fixation means are also possible.

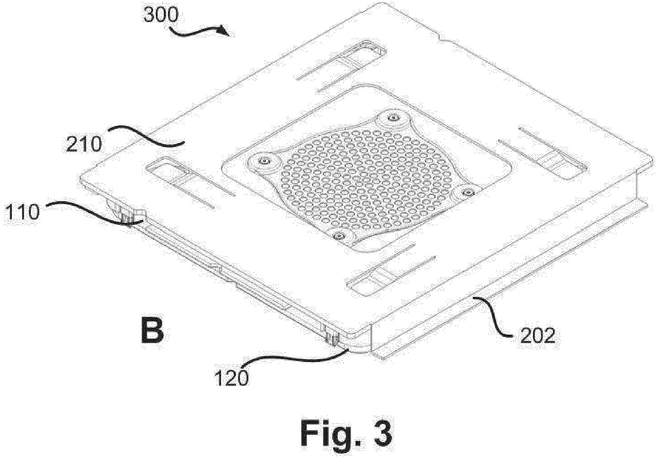

In Fig. 3 a storage system 300 comprising an EIP 100 and a two-piece clamping device 200 with upper 210 and lower 220 clamping elements is shown in an assembled state. The lower clamping element 220 is not visible in Fig. 3 as it is covered by the EIP 100.

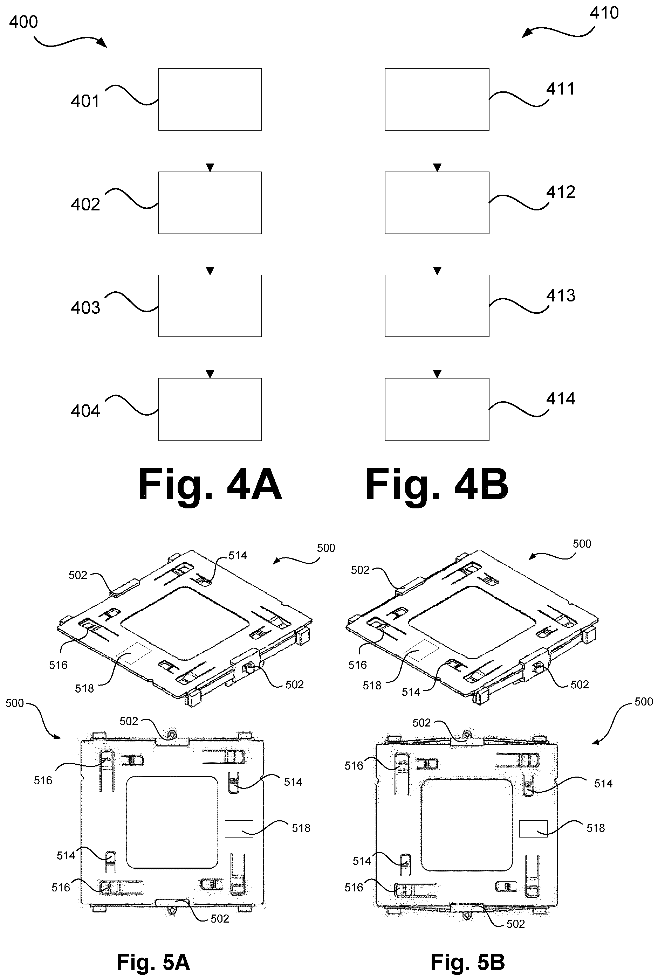

In Figures 5A and 5B a further advantageous embodiment of a clamping device 500 is schematically shown in perspective and plan views.

In contrast to the clamping device 200 shown in Figures 2 and 2A the clamping device 500 comprises only one clamping element with at least two fixation means 502. Furthermore one or more pressing means 516 are provided, which are configured to press against the respective pressure points 116 of the upper component 110 of EIP 100 to immobilize the EIP components 110, 120 relative to one another. The fixation means 502 are configured to press against a top side of the clamping element 500 and against an underside of the lower component 120 of the EIP 100, when the clamping device 500 is attached to the EIP 100. Similar to the clamping device 200, in the clamping device 500 actuators 514 are provided to immobilize the reticle within the EIP 100. The immobilization of the reticle within the EIP 100 is effected by an interaction between the actuators 514 with the retention means 114 of the EIP 100 when the clamping device 500 is attached to the EIP 100.

It is noted that the clamping device 500 shown in Fig. 5A and 5B is adapted to be usable with embodiment A of EIP 100. It is, however, to be understood that a similar one-piece clamping device 500 can be provided for embodiment B of EIP 100.

In Fig. 5A the fixation means 502 are shown in a closed position. In this particular embodiment fixation means 502 are provided on two sides of the clamping device 500 essentially in the form of a flat spring with handling and fixing elements. When attached to an EIP 100, the fixing elements of the fixation means 502 fulfil the above described function of pressing against the top side of the clamping element and the underside of the lower component 120 of EIP 100.

In Fig. 5B the fixation means 502 are shown in an open position. In this position, the fixation means 502 are spaced from the clamping element in such a way that the space between fixing elements 502 on two opposite sides of the clamping device 500 is large enough for an EIP 100 to be moved between them. Therefore, when the fixation means 502 are in the open position, the clamping device 500 may be attached to an EIP 100.

The fixation means 502 in the form of a flat spring are biased against the closed position so that, in order to be attached to the EIP 100, a lateral force has to be applied to the fixation means 502 in order to bring them into the open position.

The clamping element of the clamping device 500 is preferably essentially made of sheet metal, while the fixation means 502 can be provided in the form of flat springs of metal, a plastic or any other suitable single material or combination of materials.

The actuators 514 and pressing means 516 are preferably provided in the form of tongue shaped cut-outs, essentially as described above in connection with the embodiment of Fig. 2.

When the clamping device 500 is to be attached to an EIP 100, the fixation means 502 are forced into the open position. This may be achieved by pulling the handling elements of the fixation means in a substantially lateral direction with respect to the clamping device 500. The clamping device 500 with the fixation means 502 held in the open position is then placed on the EIP and pressed downwardly against the EIP with a preload force. Thereby, the pressing means 516 and the actuators 514 of the clamping device 500 are brought into contact with the pressing points 116 and the retention means 114 of the EIP 100, respectively. Thus, the EIP components 110, 120 and the reticle contained within the EIP 100 are immobilized relative to one another by the interaction of the clamping device 500 with the EIP 100 as soon as the preload force is applied.

The preload force is chosen such that the clamping device 500 is moved towards the EIP 100 in a normal direction relative to its main plane of extension to such an extent that the fixation means 502 can be released into the closed position without the fixation means 502 coming into contact with any part of the EIP 100. Hereby, as long as the preload force is applied, no friction is induced by the movement of the fixation means 502 into the closed position. Therefore, particle generation is effectively prevented.

As long as the preload force is applied to the clamping device 500, the fixation means 502 remain spaced from the EIP 100 and the top side of the clamping device 500 in the normal direction.

Once the fixation means 502 have reached the closed position, the applied preload force is released, so that the clamping device 500 moves away from the EIP 100, until the fixation means 502 restrict further displacement of the clamping device 500 relative to the EIP 100 by pressing against the top side of the clamping device and the underside of the lower component 120 of the EIP 100.

After the preload force has been removed from the top side of the clamping device 500, the actuators 514 and pressing means 516 still apply immobilizing forces in the normal direction to the retention means 114 and pressing points 116, respectively. These immobilizing forces are somewhat smaller than the preload force. However, the actuators 516 and retention means 514 are each designed such that the immobilizing forces effected by each of them are sufficient to immobilize the reticle within and the components 110, 120 of the EIP 100 relative to one another. For example, the pressing means 516 of one clamping element 500 effect a normal immobilization force on the pressing points 116 in the range of 1 N to 100 N, preferably in the range of 5 N to 50 N, e. g. about 20 N ± 5 N, for example 17 N, collectively or on each individual pressing point 116. This collective immobilization force is preferably equally distributed over the entirety of single pressing means 516. In the illustrated example, a quarter of the collective immobilization force is applied to each of the pressing points 116, since four pressing means 516 are provided with the clamping device 500.

As discussed above, the immobilization force applied to the reticle through the retention means 114 is preferably smaller than the one applied to the EIP components 110, 120 through the pressing points 116. For example, the immobilization force applied to the retention means 114 collectively or to each individual retention means 114 may be selected from the range of 1 N to 100 N, preferably from the range of 5 N to 50 N, and may, for example, amount to about 20 N ± 5 N, e.g. 17 N. This force is preferably equally distributed across all of the provided actuators 514, in a similar manner as described with reference to the pressing means 516.

As mentioned above, this one-piece clamping device 500 is not limited for using with embodiment A of EIP 100. Different configurations, e.g. also allowing the one-piece clamping device 500 to be used with embodiment B of EIP 100, are also provided according to the present disclosure. Those embodiments of the clamping device 500 usable with embodiment B of EIP 100 essentially correspond to the clamping device 200 usable with embodiment B of EIP 100 described above, but are provided in the form of a one-piece clamping device similar to that of the one-piece clamping device 500 as described.

It is to be understood that, in comparison with the two-piece clamping device 200, the one-piece clamping device 500 covers less of the surface of EIP 100, since it leaves substantially the whole of the lower component 120 of EIP 100 uncovered. Thus, a clamping device 500 with an orifice of the same size as the orifice 212 of clamping device 200 covers substantially less of EIP 100. For example, when attached to EIP 100, clamping device 500 leaves at least 50%, 60%, 70%, 80% or 90% of EIP 100 uncovered. In some embodiments, clamping device 500 (or 200) leaves at least the orifice(s) 112 of EIP 100 uncovered, so that fluid access from the atmosphere surrounding the clamping device 500 (or 200) towards the orifice(s) 112 is substantially unhindered.

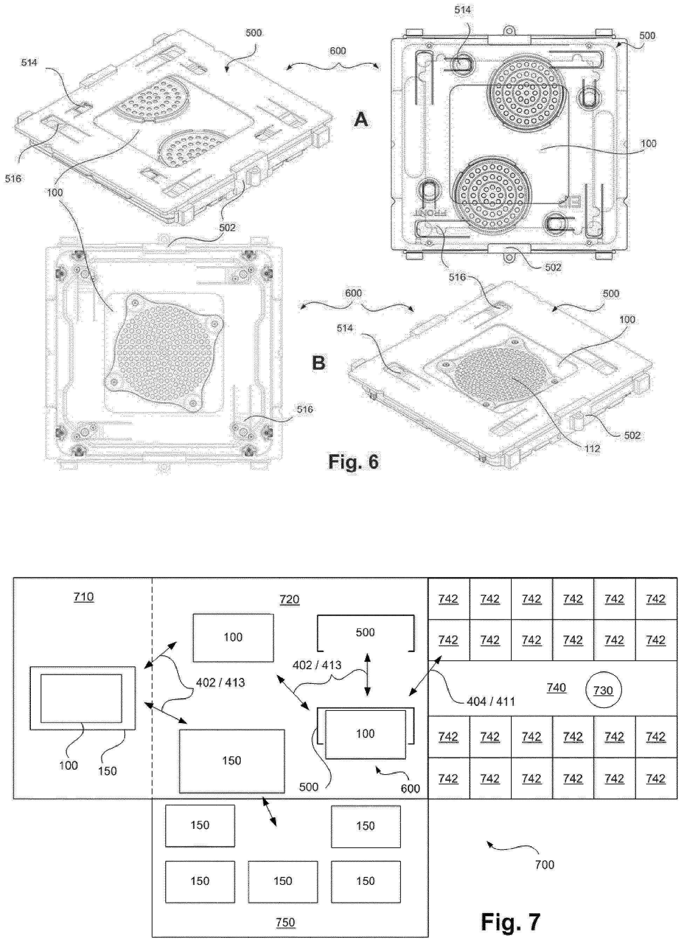

Figure 6 is a schematic representation of storage systems 600 each comprising an EIP 100 and a clamping device 500 as described above. The fixation means 502 of the clamping device 500 are in the closed position and the pressing means 516 act upon the pressing points 116 to immobilize the EIP components 110, 120 relative to one another. The actuators 514 act upon the retention means 114 to immobilize the reticle within the EIP 100.

As with the two-piece clamping device 200, one-piece clamping device 500 adapted to be usable with embodiment B of EIP 100 features pressing means 516 which simultaneously function as actuators 514. Similar to the clamping device 200, the actuators 514 of the clamping device 500 can also be provided separately from the pressing means 516, for example in the form of tongue shaped cut-outs within the pressing means 516, or in the form of cut-outs extending in an opposite direction as the pressing means 516. These modifications are not illustrated in the figures, but provide the advantage, that the force applied to the pressing points 116 can be adjusted separately from the force acting upon the retention means 114 of EIP 100.

As can be inferred from Fig. 3 and 6, the clamping device 200, 500 is of small size. Thus, the storage system 300, 600 takes up essentially the same volume as the EIP 100 on its own.

In Fig. 4A, a preferred method of operating a reticle stocker 700 for storing reticles is illustrated in a flow diagram and collectively referred to with reference numeral 400. A corresponding reticle stocker is schematically depicted in Fig. 7.

The method will be described in the following with regard to a clamping device 200 as discussed in relation to Fig. 2 and 2A. It is, however, to be understood, that corresponding steps are undertaken when using a clamping device 500 to afford a storage system 600 as described above.

In step 401, a double pod comprising an EUV outer pod (EOP) 150 and an EIP 100 contained within the EOP 150 is received from outside the stocker 700. The double pod is accepted at an outwardly facing side of an entrance terminal comprising an airlock 710 and passed through the airlock 710 to an inwardly facing side of the entrance terminal. During passing through the airlock 710, the inner volume of the airlock 710 is decontaminated, thereby ensuring that the atmosphere inside the reticle stocker 700 is not adversely affected by the receiving of the double pod.

Decontaminating the airlock 710 may comprise evacuating the airlock 710, flushing it with a fluid such as a gas, particularly an inert gas, and/or purging it with a fluid, especially an inert gas.

In step 402, the double pod is opened. Opening the double pod in this example comprises unlocking the EOP 150, removing the EOP 150 from its position surrounding the EIP 100 and moving the EOP 150 to an EOP buffer stock 750, where it may be stored until it is needed again. When the EOP 150 is removed from the EIP 100, the pressure points 116 and the retention means 114 are no longer acted upon. Therefore, at that time, the EIP components 110, 120 and the reticle contained therein are no longer immobilized relative to one another.

In step 403, a clamping device 200 is attached to the EIP 100. Thereby, a storage system 300 as shown in Fig. 3 is provided. Attaching the clamping device 200 may particularly be effected by placing the EIP 100 onto a lower clamping element 220, then covering the EIP 100 with an upper clamping element 210 and attaching the lower and upper clamping elements to one another. Preferably, placing the EIP 100 onto the lower clamping element 220 and covering the EIP 100 with the upper clamping element 210 is carried out in a manner such that essentially only normal forces are applied to the EIP 100 and torsional and lateral forces are avoided. Once the clamping device 200 is mounted to the EIP 100, the immobilization function effected by the EOP 150 before opening the double pod is effectively reinstated or emulated by the clamping device 200.

The step 403 of attaching a clamping device is performed in a slightly different way when a one-piece clamping device 500 is used. In such a case, the fixation means 502 of the clamping device 500 are forced into the open position as shown in Fig. 5B. The clamping device 500 is then moved onto the EIP 100 and pressed towards the EIP 100 with a predefined preload force in the direction perpendicular to the main plane of extension ("normal direction") of the clamping device 500. Then the fixation means 502 are released into the closed position and the preload force is released from the clamping device 500. Thereby a storage system 600 as described above is formed.

In step 404 the storage system 300, 600 is moved to a storage position within the reticle stocker.

All of the steps, especially steps 402 and 403, are carried out in such a way that the reticle contained with the EIP 100 is not moved with respect to the EIP 100 in order to prevent friction induced particle generation, as described above.

In Fig. 4B, a preferred method of operating a reticle stocker for retrieving reticles is illustrated in a flow diagram and collectively referred to with reference numeral 410.

In step 411, a storage system 300 is removed from its storage position.

In step 412, the clamping device 200 is removed from the EIP 100 to disassemble the storage system 300. To that end, the upper and lower clamping elements 210, 220 are detached from one another and the upper clamping element 210 is lifted off the EIP 100, thereby releasing the pressure points 116 and the retention means 114. At that point, the immobilization of the reticle within the EIP 100 is no longer effective.

Again, step 412 is performed in a slightly modified way, when a storage system 600 is disassembled: the clamping device 500 is removed from the EIP 100 by first applying the preload force to the clamping device 500 so that the fixation means 502 are no longer in contact with the EIP 100 or the top side of the clamping device 500. Then the fixation means 502 are forced into the open position and the preload force is released. The clamping device 500 is then lifted off the EIP 100, thereby releasing the pressure points 116 and the retention means 114.

In the case of a one-piece clamping device 500 being used, the steps 403 and 412 can be carried out without moving the EIP 100 at all. This can be achieved by leaving the EIP 100 on the lower component of the EOP 150 when attaching the clamping device 500 to the EIP 100 or placing it on the lower component of EOP 150 before detaching the clamping device 500, respectively. This is particularly favourable because it effectively prevents relative movement of the EIP components 110, 120 and the reticle, respectively.

In step 413, an EOP 150 is retrieved from the EOP buffer stock 750 and assembled around the EIP 100 to provide a double pod. When the double pod is fully assembled, the immobilization function effected by the clamping device 200 during the time of storage is provided by the EOP.

In step 414, the double pod formed in step 413 is delivered to outside the stocker 700. This may include passing the double pod through the airlock 710 mentioned above to the outwardly facing side of the entrance terminal. The airlock 710 can be purged or flushed during the passage of the double pod so as to prevent contaminants from entering the entrance terminal.

As shown in Fig. 7, the reticle stocker 700 comprises the already mentioned airlock 710, an assembler 720, which is configured to perform the steps 402, 403, 412 and 413 of the above described methods 400, 410, the EOP buffer stock 750, in which a number of EOPs 150 can be stored, and a storage unit 740 in which storage systems 300, 600 can be stored in a number of storage positions 742. A handler 730 is provided with the stocker 700 for moving the storage systems 300, 600 to and from their respective storage positions 742.

It is to be noted that the number of storage positions 742 can substantially exceed the number of EOPs 150 storable in the EOP buffer stock 750. As described above, only reticles which are needed outside the stocker 700 require an EOP 150. Therefore, a (small) number of EOPs 150 are stored in the EOP buffer stock 750, so that a double pod can be assembled on request for a reticle. However, since typically all the reticles are never required at the same time, there is no need to store an EOP 150 for each reticle stored within the storage unit 740.

In Fig. 2, 2A and 5A, the clamping device 200, 500 is additionally provided with a logging element 218, 518 (schematically shown) comprising an identification device, such as an RFID device, and one or more sensors. The RFID device 218, 518 is an information carrying element which is provided with an identification number so that each clamping device 200, 500 is distinguishable from other clamping devices 200, 500 by reading the RFID device 218, 518.

The one or more sensors included in the logging element 218, 518 are configured to detect or measure, for example, a temperature, a composition of an atmosphere surrounding the clamping device 200, 500, a pressure and/or an acceleration acting on the clamping device 200, 500. The logging element 218, 518 in this example is further configured to store readings of the one or more sensors and/or to make these readings available for further processing.

In the case of clamping devices 200, 500 being equipped with an RFID device 218, 518, for example, the method 400 can comprise providing an association of a reticle stored in combination with a certain clamping device 200, 500 with an identification number provided with the RFID device 218, 518 of the used clamping device 200, 500. This association can be stored, for example, in a central memory of the reticle stocker and/or within a central computing device of the production facility. This provides the advantage that a reticle is identifiable by the clamping device 200, 500, used for its storage and can therefore be identified while still being safely contained within the respective EIP 100.

The method may further comprise collecting data from the one or more sensors and using this data, for example to assess if further action, e.g. an inspection of a retrieved reticle, is necessary.

Advantageously, the method 410 then uses this RFID device 218, 518 of the clamping device 200, 500 in order to retrieve the reticle associated with the clamping device 200, 500. Thereby, a verification mechanism can be realised. For example, it is possible, that a storage position 742 of a given reticle within the stocker 700 is used for identifying a reticle to be retrieved from the stocker 700. When retrieving the reticle from that storage position 742, the RFID device 218, 518 of the clamping device 200, 500 can be read and the association of the identification number of the clamping device 200, 500 with the stored reticle can be checked, in order to verify, that the correct reticle is being retrieved. If the identity of the reticle stored at the specific storage location and the reticle associated with the clamping device 200, 500 differ, an identification procedure is triggered and a warning signal can be generated, so that the production does not use the reticle before its identity has been verified. This provides the advantage of a higher overall reliability of the reticle identification.

Another advantage of this association of reticles with the respective clamping device 200, 500 is that the reticles are still identifiable even in the event that they have been removed randomly from their respective storage position. This may, for example, occur during an earth quake or a similar uncontrollable situation. In conventional methods and systems, the reticles might have to be removed from their respective EIPs for identification or the conventional storage system might even be destroyed in such situations. The presently disclosed invention therefore provides a safer storage environment for EUV reticles with improved traceability.

## Claims

1. Clamping device for an EUV inner pod (EIP), the EIP (100) comprising two or more components and containing an EUV reticle, wherein the clamping device (200, 500)
is configured to immobilize the two or more components (110, 120) of the EIP (100) and the reticle relative to one another; and
to only partially cover the EIP (100), further comprising
an upper clamping element (210) and a lower clamping element (220), wherein the upper (210) and the lower (220) clamping elements are configured to be attachable to one another while accommodating the two or more EIP components (110, 120) between them.,
or further comprising one clamping element with one, two or more fixation means (502), wherein the fixation means (502) are biased towards a closed position and are configured to be moved into an open position; wherein the clamping device (500) is configured to be attachable to an EIP (100), when the fixation means are in the open position and to immobilize the EIP components (110, 120) and the reticle relative to one another, when the fixation means (502) are in the closed position.

2. Clamping device (200, 500) according to claim 1, further configured to act upon a retention means (114) of the EIP (100), the retention means (114) being configured to immobilize the reticle therein, when acted upon from outside the EIP (100), to immobilize the reticle within the EIP (100).

3. Clamping device (200, 500) according to claim 1 or 2, comprising at least 75 %, 80 %, 90 %, 95 % or 99 % of metallic materials with respect to its mass and/or volume.

4. Clamping device (200, 500) according to claim 4 or 5, wherein one clamping element (210) comprises actuators (214, 514) configured to act upon the retention means (114), when the clamping device (200, 500) is attached to the EIP (100).

5. Clamping device (200, 500) according to any one of the preceding claims having an envelope volume of less than 130 %, 120 %, 110 %, 105 % or less than 100 % of an envelope volume of an EIP (100) to which the clamping device (200, 500) is attachable.

6. Clamping device (200, 500) according to any one of the preceding claims further comprising a logging element (218, 518) comprising one or more components including
an information carrying element configured for identification of the clamping device (200, 500),
a temperature sensor,
a pressure sensor,
a concentration sensor, configured to detect or measure a concentration of one or more chemical substances in an atmosphere surrounding the clamping device (200, 500), and/or
an acceleration sensor,
wherein the logging element is configured to store and/or make available information generated using the one or more components of the logging element (218, 518).

7. Storage system (300, 600) comprising a clamping device (200, 500) according to any one of the preceding claims and an EUV inner pod (EIP) (100), wherein the EIP (100)
is configured to accommodate an EUV reticle; and
comprises two or more components (110, 120) and retention means (114) configured to immobilize the reticle when acted upon from outside the EIP (100); and
wherein the clamping device (200, 500) is attachable to the EIP (100) to immobilize the two or more components (110, 120) relative to one another and act upon the retention means (114).

8. Storage system (300, 600) according to claim 9 having an envelope volume of less than 130 %, 120 %, 110 % or 105 % of an envelope volume of the EIP (100).

9. Method of operating an EUV reticle stocker (700), comprising storing (400) EUV reticles in the reticle stocker and retrieving (410) reticles from the reticle stocker (700), wherein
the storing (400) comprises moving (404) a storage system (300, 600) according to claim 9 or 10 containing a reticle to a storage position (742) within the EUV reticle stocker (700); and
the retrieving (410) comprises removing (411) a storage system (300, 600) according to claim 9 or 10 containing a reticle from its storage position (742),wherein the storing (400), before the step of moving (404) to a storage position (742), further comprises the steps of:
receiving (401), from outside the stocker (700), a double pod comprising an EUV outer pod (EOP) (150) and an EIP (100) containing an EUV reticle, wherein the EIP (100) is entirely contained within the EOP (150);
opening (402) the EOP; and
attaching (403) a clamping device (200, 500) to the EIP (100) to immobilize EIP components (110, 120) relative to one another and to act upon retention means (114) comprised in the EIP (100) to immobilize the reticle relative to the EIP (100) to provide the storage system (300, 600).

10. Method according to claim 9, wherein receiving (401) a double pod comprises
accepting the double pod at an outwardly facing side of an entrance terminal comprising an airlock (710),
opening a first shutter of the airlock (710),
moving the double pod into the airlock (710),
closing the first shutter,
decontaminating an inner volume of the airlock (710),
opening a second shutter of the airlock (710),
moving the double pod through the second shutter to an inwardly facing side of the entrance terminal, and
closing the second shutter.

11. Method according to any one of claims 9 or 10, wherein opening (402) the EOP (150) comprises
unlocking the EOP (150),
removing the EOP (150) from around the EIP (100), and
storing the EOP (150) in an EOP buffer stock (750).

12. Method according to any one of claims 9 to 11, wherein the retrieving (410) after the step of removing (411) from the storage position (742) further comprises the steps of:
detaching (412) the clamping device (200, 500) from the EIP (100);
assembling (413) an EOP (150) around the EIP (100) to immobilize the EIP components (110, 120) and the reticle contained within the EIP (100) relative to one another, forming a double pod; and
delivering (414) the double pod to outside the stocker (700).

13. Stocker (700) for storing at least one EUV reticle, wherein each of the at least one reticle is stored in one respective EUV inner pod (EIP) (100), wherein the EIP (100) comprises two or more EIP components (110, 120) which are immobilized relative to one another by a clamping device (200, 500), wherein the EIP (100) comprises retention means (114) configured to immobilize the reticle stored inside the EIP (100) relative to the EIP (100), when acted upon from outside the EIP (100), wherein the clamping device (200, 500) acts upon the retention means (114) to immobilize the reticle stored within the EIP (100), the stocker (700) comprising:
a loading port comprising an airlock (710) and an assembler (720);
a storage unit (740) configured to store in respective storage positions (742) EIPs (100) each immobilized by one clamping device (200, 500) and each containing one reticle; and
a handler (730) configured to move the clamped EIP (100) containing the reticle to and from a respective storage position (742) within the storage unit (740) of the stocker (700);
wherein:
the airlock (710) is configured to receive a double pod comprising an EUV outer pod (EOP) (150) and an EIP (100) containing a reticle from outside the stocker (700), wherein the EOP (150) acts upon the retention means (114); and
the assembler (720) is configured to open the EOP (150) without causing movement of EIP components (110, 120) and the reticle relative to one another; to attach said clamping device (200, 500) to and remove the clamping device (200, 500) from said EIP (100) without causing movement of the EIP components (110, 120) and the reticle relative to one another; and to assemble an EOP (150) around the unclamped EIP (100).

14. Stocker (700) according to claim 13, further comprising an EOP buffer stock (750), configured to store a number of EOPs (150) in a controlled atmosphere with handling means configured to place an EOP (150) into and retrieve an EOP (150) from the EOP buffer stock (750).

## Patentansprüche

1. Klemmvorrichtung für ein EUV-Innengehäuse bzw. -Inner-Pod (EIP), wobei das EIP (100) zwei oder mehr Komponenten umfasst und eine EUV-Fotomaske bzw. ein EUV -Reticle enthält, wobei die Klemmvorrichtung (200, 500
so konfiguriert ist, dass sie die zwei oder mehr Komponenten (110, 120) des EIP (100) und der Fotomaske relativ zueinander fixiert; und
das EIP (100) nur teilweise bedeckt, ferner umfassend
ein oberes Klemmelement (210) und ein unteres Klemmelement (220), wobei das obere (210) und das untere (220) Klemmelement so konfiguriert sind, dass sie aneinander befestigt werden können, während die zwei oder mehr EIP-Komponenten (110, 120) zwischen ihnen untergebracht werden,
oder ferner umfassend ein Klemmelement mit einem, zwei oder mehreren Fixiermitteln (502), wobei die Fixiermittel (502) in Richtung einer geschlossenen Position vorgespannt sind und so konfiguriert sind, dass sie in eine offene Position bewegt werden können; wobei die Klemmvorrichtung (500) so konfiguriert ist, dass sie an einem EIP (100) angebracht werden kann, wenn sich die Fixiermittel in der offenen Position befinden, und die EIP-Komponenten (110, 120) und die Fotomaske relativ zueinander immobilisiert, wenn sich die Fixiermittel (502) in der geschlossenen Position befinden.

2. Klemmvorrichtung (200, 500) nach Anspruch 1, die ferner so konfiguriert ist, dass sie auf ein Rückhaltemittel (114) des EIP (100) einwirkt, wobei das Rückhaltemittel (114) so konfiguriert ist, dass es die Fotomaske darin fixiert, wenn von außerhalb des EIP (100) darauf eingewirkt wird, um die Fotomaske innerhalb des EIP (100) zu fixieren.

3. Klemmvorrichtung (200, 500) nach Anspruch 1 oder 2, umfassend mindestens 75 %, 80 %, 90 %, 95 % oder 99 % metallische Werkstoffe, bezogen auf ihre Masse und/oder ihr Volumen.

4. Klemmvorrichtung (200, 500) nach Anspruch 4 oder 5, wobei ein Klemmelement (210) Betätigungselemente (214, 514) umfasst, die so konfiguriert sind, dass sie auf die Rückhaltemittel (114) einwirken, wenn die Klemmvorrichtung (200, 500) an dem EIP (100) angebracht ist.

5. Klemmvorrichtung (200, 500) nach einem der vorhergehenden Ansprüche mit einem Hüllvolumen von weniger als 130 %, 120 %, 110 %, 105 % oder weniger als 100 % eines Hüllvolumens eines EIP (100), an dem die Klemmvorrichtung (200, 500) befestigbar ist.

6. Klemmvorrichtung (200, 500) nach einem der vorhergehenden Ansprüche, die ferner ein Protokollierungs- bzw. Aufzeichnungselement (218, 518) umfasst, das eine oder mehrere Komponenten enthält, umfassend
ein informationstragendes Element, das für die Identifizierung der Klemmvorrichtung (200, 500) konfiguriert ist,
einen Temperatursensor,
einen Drucksensor,
einen Konzentrationssensor, der so konfiguriert ist, dass er eine Konzentration einer oder mehrerer chemischer Substanzen in einer die Klemmvorrichtung (200, 500) umgebenden Atmosphäre erfasst oder misst, und/oder
einen Beschleunigungssensor,
wobei das Aufzeichnungselement so konfiguriert ist, dass es Informationen speichert und/oder verfügbar macht, die unter Verwendung der einen oder mehreren Komponenten des Aufzeichnungselements (218, 518) erzeugt wurden.

7. Speichersystem (300, 600) mit einer Klemmvorrichtung (200, 500) nach einem der vorhergehenden Ansprüche und einem EUV-Innenbehälter bzw. Inner Pod (EIP) (100), wobei das EIP (100)
so konfiguriert ist, dass es eine EUV-Fotomaske aufnehmen kann; und
zwei oder mehr Komponenten (110, 120) und Rückhaltemittel bzw. Haltemittel (114) umfasst, die so konfiguriert sind, dass sie das Fotomaske unbeweglich machen, wenn von außerhalb der EIP (100) darauf eingewirkt wird; und
wobei die Klemmvorrichtung (200, 500) an dem EIP (100) angebracht werden kann, um die zwei oder mehr Komponenten (110, 120) relativ zueinander zu fixieren und auf die Rückhaltemittel (114) einzuwirken.

8. Speichersystem (300, 600) nach Anspruch 9 mit einem Hüllvolumen von weniger als 130 %, 120 %, 110 % oder 105 % eines Hüllvolumens des EIP (100).

9. Verfahren zum Betreiben eines EUV-Fotomaskenlagers bzw. Reticle-Stockers (700), das das Lagern (400) von EUV-Fotomasken in dem Fotomaskenlager und das Entnehmen (410) von Fotomasken aus dem Fotomaskenlager (700) umfasst, wobei
das Speichern (400) das Bewegen (404) eines Speichersystems (300, 600) nach Anspruch 9 oder 10, das eine Fotomaske enthält, zu einer Speicherposition (742) innerhalb des EUV-Retikel-Lagers (700) umfasst; und
das Entnehmen (410) das Entfernen (411) eines Speichersystems (300, 600) nach Anspruch oder 10, das eine Fotomaske enthält, aus seiner Speicherposition (742) umfasst, wobei das Speichern (400) vor dem Schritt des Bewegens (404) zu einer Speicherposition (742) ferner die folgenden Schritte umfasst:
Empfangen (401) eines Doppelpods bzw. Doppelgehäuses von außerhalb des Stockers (700), das einen EUV-Außenpod (EOP) (150) und einen EIP (100) umfasst, der ein EUV-Fotomaske enthält, wobei der EIP (100) vollständig innerhalb des EOP (150) enthalten ist;
Öffnen (402) des EOP; und
Anbringen (403) einer Klemmvorrichtung (200, 500) an der EIP (100), um die EIP-Komponenten (110, 120) relativ zueinander zu fixieren und auf die in der EIP (100) enthaltenen Haltemittel (114) einzuwirken, um das Retikel relativ zur EIP (100) zu fixieren, um das Speichersystem (300, 600) bereitzustellen.

10. Verfahren nach Anspruch 9, wobei die Aufnahme (401) eines Doppelpods Folgendes umfasst
Aufnahme des Doppelpods an einer nach außen gerichteten Seite eines Eingangsterminals mit einer Schleuse (710),
Öffnen eines ersten Verschlusses der Schleuse (710),
Bewegen des Doppelpods in die Luftschleuse (710),
Schließen des ersten Verschlusses,
Dekontaminierung eines Innenvolumens der Schleuse (710),
Öffnen eines zweiten Verschlusses der Schleuse (710),
Bewegen des Doppelpods durch den zweiten Verschluss zu einer nach innen gerichteten Seite des Eingangsterminals, und
Schließen des zweiten Verschlusses.

11. Verfahren nach einem der Ansprüche 9 oder 10, wobei das Öffnen (402) des EOP (150) Folgendes umfasst
die Entriegelung des EOP (150),
Entfernen des EOP (150) um die EIP (100) herum, und
Lagerung des EOP (150) in einem EOP-Pufferlager (750).

12. Verfahren nach einem der Ansprüche 9 bis 11, wobei das Entnehmen (410) nach dem Schritt des Entfernens (411) aus der Lagerposition (742) ferner die folgenden Schritte umfasst:
Lösen (412) der Klemmvorrichtung (200, 500) von dem EIP (100);
Montieren (413) eines EOP (150) um das EIP (100) herum, um die EIP-Komponenten (110, 120) und die in dem EIP (100) enthaltene Fotomaske relativ zueinander zu fixieren, wodurch ein Doppelpod gebildet wird; und
liefern (414) des Doppelpods an die Außenseite des Stockers (700).

13. Stocker bzw. Lagereonrichtung (700) zum Lagern mindestens eines EUV-Reticles bzw. einer EUV-Fotomaske, wobei jedes der mindestens einen Fotomaske in einem jeweiligen EUV-Innenpod (EIP) (100) gelagert ist, wobei der EIP (100) zwei oder mehr EIP-Komponenten (110, 120) umfasst, die durch eine Klemmvorrichtung (200, 500) relativ zueinander fixiert sind, wobei der EIP (100) Rückhaltemittel (114) umfasst, die so konfiguriert sind, dass sie das in dem EIP (100) gelagerte Reticles relativ zum EIP (100) fixieren, wenn von außerhalb des EIP (100) darauf eingewirkt wird, wobei die Klemmvorrichtung (200, 500) auf die Rückhaltemittel (114) einwirkt, um das in dem EIP (100) gelagerte Reticle zu fixieren, wobei der Stocker (700) umfasst:
eine Ladeöffnung mit einer Schleuse (710) und einer Montagevorrichtung (720);
eine Lagereinheit (740), die so konfiguriert ist, dass sie in entsprechenden Speicherpositionen (742) EIPs (100) speichert, die jeweils durch eine Klemmvorrichtung (200, 500) fixiert sind und jeweils ein Fotomaske enthalten; und
eine Handhabungseinrichtung (730), die so konfiguriert ist, dass sie den eingespannten EIP (100), die das Fotomaske enthält, zu und von einer jeweiligen Lagerposition (742) innerhalb der Lagereinheit (740) der Lagereinrichtung (700) bewegt;
wobei
die Luftschleuse (710) so konfiguriert ist, dass sie eine Doppelpod mit einer EUV-Außenkapsel (EOP) (150) und einer EIP (100), die ein Retikel enthält, von außerhalb des Stockers (700) aufnimmt, wobei die EOP (150) auf das Rückhaltemittel (114) wirkt;
die Montagevorrichtung (720) so konfiguriert ist, dass sie das EOP (150) öffnet, ohne eine Bewegung der EIP-Komponenten (110, 120) und der Fotomaske relativ zueinander zu bewirken; die Klemmvorrichtung (200, 500) an dem EIP (100) anbringt und die Klemmvorrichtung (200, 500) von dem EIP (100) entfernt, ohne eine Bewegung der EIP-Komponenten (110, 120) und der Fotomaske relativ zueinander zu bewirken; und ein EOP (150) um das nicht eingeklemmte EIP (100) herum zusammensetzt.

14. Stocker (700) nach Anspruch 13, die ferner ein EOP-Pufferlager (750) umfasst, das so konfiguriert ist, dass es eine Anzahl von EOPs (150) in einer kontrollierten Atmosphäre lagert, mit Handhabungsmitteln, die so konfiguriert sind, dass sie ein EOP (150) in das EOP-Pufferlager (750) legen und ein EOP (150) daraus entnehmen.

## Revendications

1. Dispositif de serrage pour un pod intérieur EUV (EIP), l'ElP (100) comprenant deux composants ou plus et contenant un réticule EUV, dans lequel le dispositif de serrage (200, 500
est configuré pour immobiliser les deux composants ou plus (110, 120) de l'ElP (100) et le réticule l'un par rapport à l'autre ; et
pour ne recouvrir que partiellement l'ElP (100), comprenant en outre
un élément de serrage supérieur (210) et un élément de serrage inférieur (220), dans lesquels les éléments de serrage supérieur (210) et inférieur (220) sont configurés pour être attachés l'un à l'autre tout en accueillant les deux ou plusieurs composants EIP (110, 120) entre eux...,
ou comprenant en outre un élément de serrage avec un, deux ou plusieurs moyens de fixation (502), dans lequel les moyens de fixation (502) sont orientés vers une position fermée et sont configurés pour être déplacés vers une position ouverte ; dans lequel le dispositif de serrage (500) est configuré pour être fixé à un EIP (100), lorsque les moyens de fixation sont en position ouverte et pour immobiliser les composants EIP (110, 120) et le réticule l'un par rapport à l'autre, lorsque les moyens de fixation (502) sont en position fermée.

2. Dispositif de serrage (200, 500) selon la revendication 1, configuré en outre pour agir sur un moyen de rétention (114) de l'ElP (100), le moyen de rétention (114) étant configuré pour immobiliser le réticule à l'intérieur, lorsqu'il est actionné de l'extérieur de l'ElP (100), pour immobiliser le réticule à l'intérieur de l'EIP (100).

3. Dispositif de serrage (200, 500) selon la revendication 1 ou 2, comprenant au moins 75 %, 80 %, 90 %, 95 % ou 99 % de matériaux métalliques par rapport à sa masse et/ou son volume.

4. Dispositif de serrage (200, 500) selon la revendication 4 ou 5, dans lequel un élément de serrage (210) comprend des actionneurs (214, 514) configurés pour agir sur le moyen de rétention (114), lorsque le dispositif de serrage (200, 500) est fixé à l'ElP (100).

5. Dispositif de serrage (200, 500) selon l'une quelconque des revendications précédentes ayant un volume d'enveloppe inférieur à 130 %, 120 %, 110 %, 105 % ou moins de 100 % du volume d'enveloppe d'un EIP (100) auquel le dispositif de serrage (200, 500) peut être fixé.

6. Dispositif de serrage (200, 500) selon l'une quelconque des revendications précédentes comprenant en outre un élément d'enregistrement (218, 518) comprenant un ou plusieurs composants dont
un élément porteur d'informations configuré pour l'identification du dispositif de serrage (200, 500),
un capteur de température,
un capteur de pression,
un capteur de concentration, configuré pour détecter ou mesurer une concentration d'une ou plusieurs substances chimiques dans une atmosphère entourant le dispositif de serrage (200, 500), et/ou
un capteur d'accélération,
l'élément de journalisation est configuré pour stocker et/ou mettre à disposition les informations générées à l'aide d'un ou plusieurs composants de l'élément de journalisation (218, 518).

7. Système de stockage (300, 600) comprenant un dispositif de serrage (200, 500) selon l'une quelconque des revendications précédentes et un pod intérieur EUV (EIP) (100), dans lequel l'EIP (100)
est configuré pour accueillir un réticule EUV ; et
comprend deux composants ou plus (110, 120) et des moyens de rétention (114) configurés pour immobiliser le réticule lorsqu'il est actionné de l'extérieur du PIE (100) ; et
le dispositif de serrage (200, 500) peut être fixé à l'EIP (100) pour immobiliser les deux composants ou plus (110, 120) l'un par rapport à l'autre et agir sur les moyens de rétention (114).

8. Système de stockage (300, 600) selon la revendication 9 ayant un volume d'enveloppe inférieur à 130 %, 120 %, 110 % ou 105 % d'un volume d'enveloppe de l'EIP (100).

9. Méthode de fonctionnement d'un stockeur de réticules EUV (700), comprenant le stockage (400) de réticules EUV dans le stockeur de réticules et la récupération (410) de réticules du stockeur de réticules (700), dans laquelle
le stockage (400) consiste à déplacer (404) un système de stockage (300, 600) selon la revendication 9 ou 10 contenant un réticule vers une position de stockage (742) à l'intérieur du stockeur de réticules EUV (700) ; et
la récupération (410) comprend le retrait (411) d'un système de stockage (300, 600) selon la revendication 9 ou 10 contenant un réticule de sa position de stockage (742), dans lequel le stockage (400), avant l'étape de déplacement (404) vers une position de stockage (742), comprend en outre les étapes suivantes :
réception (401), depuis l'extérieur du stockeur (700), d'un double pod comprenant un pod extérieur EUV (EOP) (150) et un EIP (100) contenant un réticule EUV, dans lequel l'ElP (100) est entièrement contenu dans l'EOP (150) ;
l'ouverture (402) de l'EOP ; et
fixer (403) un dispositif de serrage (200, 500) à l'EIP (100) pour immobiliser les composants de l'EIP (110, 120) les uns par rapport aux autres et pour agir sur les moyens de rétention (114) compris dans l'EIP (100) afin d'immobiliser le réticule par rapport à l'ElP (100) pour fournir le système de stockage (300, 600).

10. Méthode selon la revendication 9, dans laquelle la réception (401) d'une double cosse comprend
accepter la double capsule sur un côté orienté vers l'extérieur d'un terminal d'entrée comprenant un sas (710),
ouverture d'un premier volet du sas (710),
déplacer la double nacelle dans le sas (710),
fermeture du premier volet,
la décontamination d'un volume intérieur du sas (710),
l'ouverture d'un second volet du sas (710),
déplacer la double capsule à travers le second volet jusqu'à un côté du terminal d'entrée tourné vers l'intérieur, et
fermeture du second volet.

11. Méthode selon l'une quelconque des revendications 9 ou 10, dans laquelle l'ouverture (402) de l'EOP (150) comprend
le déverrouillage de l'EOP (150),
retirer l'EOP (150) d'autour de l'EIP (100), et
le stockage de l'EOP (150) dans un stock tampon d'EOP (750).

12. Méthode selon l'une quelconque des revendications 9 à 11, dans laquelle la récupération (410) après l'étape de retrait (411) de la position de stockage (742) comprend en outre les étapes suivantes :
détacher (412) le dispositif de serrage (200, 500) de l'ElP (100) ;
l'assemblage (413) d'un EOP (150) autour de l'ElP (100) pour immobiliser les composants de l'EIP (110, 120) et le réticule contenu dans l'EIP (100) l'un par rapport à l'autre, formant ainsi une double capsule ; et
livrer (414) la double cosse à l'extérieur du stockeur (700).

13. Stockeur (700) pour stocker au moins un réticule EUV, dans lequel chacun des au moins un réticule est stocké dans un pod intérieur EUV (EIP) (100) respectif, dans lequel l'ElP (100) comprend deux ou plusieurs composants EIP (110, 120) qui sont immobilisés l'un par rapport à l'autre par un dispositif de serrage (200, 500), dans lequel l'ElP (100) comprend des moyens de rétention (114) configurés pour immobiliser le réticule stocké à l'intérieur de l'ElP (100) par rapport à l'ElP (100), lorsqu'il est actionné depuis l'extérieur de l'EIP (100), dans lequel le dispositif de serrage (200, 500) agit sur les moyens de rétention (114) pour immobiliser le réticule stocké à l'intérieur de l'EIP (100), le stockeur (700) comprenant :
un port de chargement comprenant un sas (710) et un assembleur (720) ;
une unité de stockage (740) configurée pour stocker dans des positions de stockage respectives (742) des EIP (100) immobilisés chacun par un dispositif de serrage (200, 500) et contenant chacun un réticule ; et
un dispositif de manutention (730) configuré pour déplacer l'EIP (100) contenant le réticule vers et depuis une position de stockage respective (742) à l'intérieur de l'unité de stockage (740) du stockeur (700) ;
dans lequel
le sas (710) est configuré pour recevoir une double capsule comprenant une capsule extérieure EUV (EOP) (150) et une capsule extérieure EIP (100) contenant un réticule provenant de l'extérieur du stockeur (700), la capsule extérieure EOP (150) agissant sur le moyen de rétention (114)
l'assembleur (720) est configuré pour ouvrir l'EOP (150) sans provoquer de mouvement des composants EIP (110, 120) et du réticule les uns par rapport aux autres ; pour fixer ledit dispositif de serrage (200, 500) audit EIP (100) et retirer le dispositif de serrage (200, 500) dudit EIP (100) sans provoquer de mouvement des composants EIP (110, 120) et du réticule les uns par rapport aux autres ; et pour assembler un EOP (150) autour de l'EIP (100) non serré.

14. Stockeur (700) selon la revendication 13, comprenant en outre un stock tampon EOP (750), configuré pour stocker un certain nombre de EOP (150) dans une atmosphère contrôlée avec des moyens de manipulation configurés pour placer un EOP (150) dans le stock tampon EOP (750) et en extraire un EOP (150).
